Europäisches Patentamt

European Patent Office

Office européen des brevets

(11) Publication number : **0 665 471 A2**

# (12) EUROPEAN PATENT APPLICATION

(21) Application number : 95400169.9

(22) Date of filing : 26.01.95

(51) Int. Cl.⁶ : **G03F 7/34**, G03F 7/11

(30) Priority : 28.01.94 US 189079

(43) Date of publication of application :
02.08.95 Bulletin 95/31

(84) Designated Contracting States :
DE FR GB IT

(71) Applicant : **MINNESOTA MINING AND MANUFACTURING COMPANY**
3M Center,
P.O. Box 33427
St. Paul, Minnesota 55133-3427 (US)

(72) Inventor : **Wang, Paul J., Minnesota Mining & Manuf. Co.,**
2501 Hudson Road,
P.O. Box 33427
Saint Paul, Minnesota 55133-3427 (US)

(74) Representative : **Warcoin, Jacques et al**
Cabinet Régimbeau,
26, avenue Kléber
F-75116 Paris (FR)

(54) **Release layer for thermally developed flexographic printing plates.**

(57)   Thermally developable flexographic printing plates benefit from a release layer which is also particularly suitable for thermal development. The release layer of this invention, comprises a cellulose based polymer, e.g. such as hydroxypropyl cellulose, which contacts the photosensitive elastomeric layer of the flexographic plate. The photosensitive elastomeric composition may be imagewise cured by exposure to actinic radiation through an imaging bearing film which may be laid against the layer of cellulosic polymer. The image bearing film is easily removed after the photoinitiated curing of the photosensitive elastomeric composition. The imagewise cured elastomeric layer may then be developed. The plate may be thermally developed by contacting the plate with an absorbent material at a temperature sufficient to soften or melt the release layer and the unexposed, uncured portions of the photosensitive, elastomeric layer.

EP 0 665 471 A2

1. Field of the Invention

This invention relates to flexographic printing plates and particularly to release layers suitable for use in thermally developed flexographic printing plates.

2. Background of the Invention

Flexography is a term broadly applicable to a printing format that uses a flexible substrate bearing an elastomeric or rubbery relief printing surface.

The first flexographic printing plates were produced from natural or synthetic rubber compositions which were cured chemically under heat and pressure in a mold utilizing conventional rubber curatives such as mercapto compounds (Flexography: Principles and Practices, 3rd Edition, Flexographic Technical Association, p. 158-162). More recently, photopolymer elastomeric compositions (elastomer containing compositions curable upon exposure to actinic radiation) have been used to produce relief printing plates. For example, U.S. Patent 4,162,919 describes the use of a photosensitive composition containing a block copolymer as an elastomeric polymeric binder, a compatible ethylenically unsaturated monomer, and a Photoinitiator. Similarly, British Patent 1,454,191 describes the use of an elastomeric Polyurethane based Photosensitive layer in a flexographic printing plate.

To produce the flexographic printing plate, the photopolymer is image-wise exposed to actinic radiation. This may be accomplished by contacting a negative or image bearing film with the flexographic printing plate followed by irradiation. Generally, a release layer on the surface of the printing plate above the layer of photopolymer is used to facilitate removal of the negative or image bearing film from the flexographic printing plate. If no release layer is used, the film frequently sticks to the tacky surface of the printing plate, and it becomes very difficult to remove the film without damaging the printing surface.

The release layer is also helpful in avoiding trapped air between the film and the plate which may interfere with the photoinitiated curing process. The release layer should be flexible, transparent, coatable, and nontacky. However, there must be sufficient adhesion to prevent the release layer from peeling away from the plate before exposure of the plate to actinic radiation.

The release layer is generally removed from the exposed plate during the development process. After removing the negative or image bearing film, the flexographic printing plate is developed. Development usually is accomplished by spraying, washing or brushing the surface of the plate with a solvent as in U.S. Patent 4,162,919 and British Patent 1,454,191. European Patent 261,910 describes systems that can be developed by aqueous washing have been described. Typically, a polyamide is used as a release layer in solvent developing systems such as that found in U.S. Patent 4,452,879.

In contrast, International Patent application WO 91/06893 describes the use of hydroxyalkyl cellulose release layers for systems that are aqueous or semi-aqueous developable. The alkyl group of that patent's release layer has one to five carbon atoms and may be linear or branched.

Both the solvent wash and aqueous wash systems are time consuming since drying for extended periods (I to 24 hours) is necessary to remove residual developer solution. In addition, these development systems produce potentially toxic by-product wastes (both the solvent and materials carried off by the solvent such as unreacted ethylenically unsaturated monomer) in the development process.

To avoid these problems, a thermal development process may be used. In this process, the photosensitive layer, which has been image exposed to actinic radiation, is contacted with an absorbent layer at a temperature sufficient to cause the unexposed, uncured portions of the photosensitive layer to soften or melt and flow into the absorbent material. See U.S. Patents No. 3,264,103 and 5,015,556 for planographic and relief imaging, respectively. Unfortunately, release layers used in conventionally developed printing plates are not necessarily satisfactory in thermally developed printing plates.

Summary of Invention

The present invention provides a flexible sheet suitable for use as a flexographic printing plate comprising
A) a flexible substrate,
B) a layer of a photosensitive, elastomeric composition that in the uncured state will not disperse in water, water and surfactant, or water and a miscible solid, and
C) a layer comprising a cellulose-based polymer that is removable during thermal development of the printing plate.

A flexographic printing plate may be produced from this sheet by imagewise exposing the sheet to actinic radiation and thermally developing the sheet.

Detailed Description of the Invention

The present invention provides a thermally developable flexographic printing plate with a suitable release layer. The printing Plate is composed of materials such that it is non-aqueous developable, i.e., neither water, water and surfactant, nor water and miscible organic solvent can be used to develop the plate by readily dispersing the uncured composition after exposure of the photosensitive layer to actinic radiation. The release layer comprises a cellulose based polymer, which contacts the photosensitive elastomeric layer of the flexographic plate. The photosensitive elastomeric composition may be imagewise cured by exposure to actinic radiation through an imaging bearing film which may be laid against the layer of cellulosic polymer. The image bearing film is easily removed after the photoinitiated curing of the photosensitive elastomeric composition. The imagewise cured elastomeric layer may then be developed. The plate may be thermally developed by contacting the plate with an absorbent material at a temperature sufficient to soften or melt the release layer and the unexposed, uncured portions of the photosensitive, elastomeric layer.

The substrate of the multilayer, photosensitive sheet of the present invention may be any flexible material including metal sheets, plastic films, open or closed celled foams, compressible rubber, or some combination of the preceding materials. Various plastics, especially polyesters such as polyethylene terephthalate (PET), are well suited for use as the flexible substrate. The substrate optionally may be surface treated for better adhesion. one example of such a surface treatment is corona treating the surface followed by use of a primer such as an aziridene, as described in U.S. Application Ser. No. 08/189,075. The substrate is preferably about 0.07 to 1.5 mm thick.

The photosensitive, elastomeric layer should be at least 0.3 mm thick but no more than 3.0 mm thick, preferably no more than 1.5 mm. The photosensitive elastomeric composition should be such that it is suitable for thermal development, i.e., the uncured elastomeric composition must soften or melt at a reasonable processing or developing temperature but not be subject to cold flow, i.e., dimensional change, during normal storage. The preferred processing or developing temperatures are in the range of about 95°C to about 150°C.

The photosensitive, elastomeric compositions of the present invention are not aqueous dispersible, i.e., even in the uncured state these compositions will not disperse in water, water and surfactant, or water and a miscible organic solvent. Thus, the flexographic plates of the present invention are not aqueous developable.

A non-limiting example of such an elastomeric composition comprises a thermoplastic elastomeric block copolymer mixed with a cross-linking agent and a photoinitiator. The elastomeric block copolymer is preferably an A-B-A type block copolymer, where A is a nonelastomeric block, preferably a vinyl polymer and most preferably polystyrene and B is an elastomeric block, preferably polybutadiene or polyisoprene. The nonelastomer to elastomer ratio is preferably in the range of from 10:90 to 35:65. The cross-linking agent in this embodiment may he an ethylenically unsaturated compound with at least one terminal ethylenic group that is compatible with the block copolymer, e.g. multi-functional acrylates or methacrylates, or polyacryloyl oligomers. The following compounds are illustrative of, but not an exhaustive list of, suitable cross-linking agents: ethylene glycol diacrylate, hexanediol diacrylate, diethylene glycol diacrylate, glycerol diacrylate, trimethylol propane triacrylate, hexanediol dimethacrylate, glycerol triacrylate, trimethylolpropane triacrylate, ethylene glycol dimethacrylate, 1,3-propanediol dimethacrylate, 1,2,4-butanetriol trimethacrylate, and 1,4-butanediol diacrylate. For a more exhaustive list of suitable compounds see U.S. Patent 4,400,459. A mixture of monofunctional and multi-functional acrylates or methacrylates may be used. However, if using such a mixture, it is desirable to have an average of at least 1.3 acrylate groups per molecule of cross-linking agent. It is preferable to have an average of at least 1.7 acrylate groups per molecule of cross-linking agent, and it is most preferable to have at least 2.1 acrylate groups per molecule of cross-linking agent. If a polyacryloyl oligomer is used, that oligomer should preferably have a molecular weight greater than 1000.

Other suitable photosensitive elastomers that may be used include polyurethane elastomers. An example of a suitable polyurethane elastomer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a more complete discussion of some of these materials see U.S. Patent 5,015,556.

The photosensitive elastomeric layer should include a photoinitiator. The photoinitiator is a compound which generates free radicals upon exposure to actinic radiation. Any of the known classes of photoinitiators, particularly free radical photoinitiators such as quinones, benzophenones, benzoin ethers, aryl ketones, peroxides, biimidazoles, diaryliodoniums, triarylsulfoniums and phosphoniums, and diazoniums, may be used. Alternatively, the photoinitiator may be a mixture of compounds, one of which provides the free radicals when caused to do so by a sensitizer activated by radiation, may be used.

Additional additives to the photosensitive layer include colorants, processing aids, antioxidants, spectral sensitizers and antiozonants. Processing aids may be such things as low molecular weight polymers compatible with the elastomeric block copolymer, such as a low molecular weight $\alpha$-methylstyrene polymer or copolymer. Antiozonants include hydrocarbon waxes, norbornenes, and vegetable oils. Suitable antioxidants include alkylated phenols, alkylated bisphenols, polymerized trimethyldihydroquinone, and dilauryl thiopropinoate.

The release layer must be flexible, transparent, coatable, and nontacky. A thin layer, preferably having a thickness of at least 0.5 microns, but less than 10 microns, more preferably less than 4 microns, is suitable.

The release layer must be such that it is removable by contact with an absorbent material in the range of acceptable developing temperatures for the flexographic plate used.

The release layer of the present invention is a thermoplastic cellulose-based polymer. Applicants have found that the softening point and the melt viscosity are important properties. The melt viscosity must be low enough that the release layer is fully removable by thermal development. The ranges for acceptable softening temperatures and melt viscosities vary with the photosensitive composition used in the relief layer. For example, a cellulose-based polymer with a high softening temperature may be suitable for use in a flexographic printing plate with a high developing temperature, while the same cellulose based polymer would not be suitable for use in a flexographic printing plate with a lower developing temperature.

In a preferred embodiment, the flexographic printing plate is developed at temperatures in the range from about 95°C to about 150°C. For such flexographic printing plates, the cellulose-based polymer of the release layer preferably has a softening temperature less than about 130°C, more preferably less than about 120°C.

The cellulose-based polymer release layer may comprise a hydroxyalkyl cellulose. However, not all hydroxyalkyl celluloses are suitable. High molecular weight hydroxypropyl cellulose tends to be too viscous at thermal developing temperatures for removal by thermal development. Hydroxyethyl celluloses with molecular weights as low as 90,000 have also been difficult to remove. The preferred hydroxyalkyl cellulose is hydroxypropyl cellulose with a molecular weight less than 300,000, and preferably less than 140,000.

The release layer may further comprise an antistatic agent, preferably no more than 5% by weight of the release layer. One such suitable antistatic agent is vanadium pentoxide. The antistatic agent is removed along with the rest of the release layer during development of the flexographic printing plate. In an alternate embodiment, the antistatic agent may be a separate layer from the release layer. This separate antistatic layer is preferably located between the release layer and a removable cover sheet. The antistatic layer may comprise such materials as vanadium pentoxide or quaternary ammonium compounds. If the antistatic compound is a separate layer, such as vanadium pentoxide in a sulfonated polyester, this separate layer preferably is also removed during development of the flexographic printing plate.

The release layer is often directly above the photosensitive elastomeric layer. Occasionally, however, a pigment layer cap is desired on top of the photosensitive curable relief layer. When such a pigment layer is used, the release layer should be on top of the pigment layer. The pigment layer is preferably 10 to 100 microns thick and should be a photosensitive, elastomeric composition. Frequently, the binder of the pigment layer is the same as or similar to the composition of the photosensitive relief layer with the addition of a pigment.

Other optional layers may also be added. Adhesive layers may be used wherever necessary. A second non-photosensitive elastomeric layer may be added to provide the desired hardness for the flexographic printing plate or to provide a clean floor. This optional layer may be between the substrate and the photosensitive layer, or, if used only as a hardness adjustment, on the opposite side of the substrate from the photosensitive layer. An easily removable cover layer may be desired above the release layer for protection of that layer during storage. This cover layer is removed prior to exposure of the plate to actinic radiation. Suitable materials for this protective layer include polyesters films.

Examples

Example 1

Seventy five (75) grams of hydroxypropyl cellulose, having a molecular weight of about 80,000, along with 3 g of vanadium pentoxide and 3 g of surfactant were stirred into distilled water at room temperature to make a 2.5% solution. The solution was coated onto a 4 mil (0.1 mm) polyester film to give a dry coating weight of 4 mg/cm², corresponding to a thickness of roughly 1.0 micron. Onto this release layer a curable pigment layer was coated. The binder of the pigment layer contains:

65.6 wt% styrene-isoprene-styrene block copolymer;
24.7% polybutadiene diacrylate;
7.4% alpha methyl styrene copolymer;

1.3% Irgacure™ 651 (photoinitiator);
0.5% Irganox™ 1076 (antioxidant); and
0.5% Cyanox™ LDTP (antioxidant).

These ingredients were dissolved in 80/20 toluene/MEK to make a 15% solution. Magenta and cyan pigments were dispersed in the above solution using lecithin as the dispersant. The resulting solution had a 4% by weight of binder pigment loading. The pigment layer with a coating weight of 18 mg/cm² (4.3 microns) was coated onto the hydroxypropyl cellulose. A silicone-urea coated polyester liner is laminated onto the pigment layer for protective purposes.

Example 2

After peeling off the silicone-urea coated polyester liner, the pigment layer of a multi-layer sheet as described in Example 1 was laminated onto a photopolymerizable element, comprising a photopolymerizable elastomer on a flexible substrate. The photopolymerizable elastomer composition was 50.3% styrene-isoprene-styrene block copolymer, 40.0% polybutadiene diacrylate, 7.4% alpha methyl styrene copolymer, 0.5% Irganox™ 651, 1.3% photoinitiator, and 0.5% antiozonant. The pigment layer contacted to the photopolymerizable elastomer. The 4 mil (0.1 mm) polyester sheet was then removed, thereby exposing the hydroxypropyl cellulose. A negative image bearing film was then placed on the hydroxypropyl cellulose layer. The photopolymerizable elastomer and pigment layers were image-wise cured by exposure to ultraviolet light through the negative image bearing film. The negative image bearing film was easily removed from the hydroxypropyl cellulose layer.

The image-wise cured flexographic plate was developed by contacting the plate with an absorbent material at elevated temperature. The roll carrying the absorbent material was maintained at 177°C while the roll carrying the flexographic plate was maintained at approximately 60°C. Five cycles, or contacts, provided good clean-out of the non-irradiated regions, a good relief depth, a clean image and a substantially smooth floor. Printing press trials using both water and solvent based inks showed good image quality indicating complete removal of the hydroxypropyl cellulose layer.

Comparative Example 1

The polyvinyl alcohols indicated in Table I were each prepared as 2.5% solutions in water with Surfacto™ 365 (Air Product Co.) surfactant.

Table 1

| Type of PVA | Molecular Weight Range | Degree of hydrolyzation |
|---|---|---|
| Airvol™103* | 13,000-23,000 | fully |
| Airvol™107 | 31,000-50,000 | fully |
| Airvol™203 | 13,000-23,000 | partially |
| Airvol™205 | 31,000-50,000 | partially |

* Airvol is a product of Air Product Co.

The flexographic plates were prepared, exposed and developed as described in Examples 1 and 2. However, thermal development with a contact roll temperature of 183°C and a temperature of 67°C for the roll carrying the flexographic plate were insufficient to melt the polyvinyl alcohols due to strong hydrogen bonding. The polyvinyl alcohols began to degrade before they would melt sufficiently for thermal development.

Comparative Example 2

An extrudable polyvinyl alcohol made by blending glycerine into a polyvinyl alcohol was also tried as a release coat. Vinex™ 2019 (Air Product Co.), the lowest melting point extrudable polyvinyl alcohol in the Vinex™ line has a melting point between 180 and 190°C. Plates using Vinex™ 2019 as a release layer gave poor results because the Vinex™ 2019 melting temperature was too high for effective removal during thermal development.

Examples 3-6 and Comparative Examples 3-7

The materials listed in Table 2 were used in release layers. The Klucel™ (Aqualon) materials are hydroxypropyl cellulose. Natrosol™ 250 LR (Aqualon) is a hydroxyethyl cellulose. Methocel™ F4M (Dow Chemical Co.) is a hydroxy propyl methyl cellulose. Solutions were made by adding 2.5 g of sample material to 100.0 ml of distilled water, 2.0 ml of Surfacto 365 10% solution, and 3.0 ml of Rhodamine B 0.5% solution. A drop of germicide was also added. The Rhodamine B gave the solution a pink tint so that the coating would be easily visible. The solutions were coated onto a 0.1 micron polyester sheet using a #19 Meyer bar and allowed to dry. The coatings were then laminated at approximately 110°C to a photopolymerizable element comprising a flexible substrate coated with 50.3% styrene-isoprene-styrene block copolymer, 40.0% polybutadiene diacrylate, 7.4% alpha methyl styrene copolymer, 0.5% Irganox™ 651, 1.3% photoinitiator, and 0.5% antiozonant.

Table 2

| Ex. # | Material | Molecular Weight | Softening or melting temp. (C) | Developing roll temp./surface temp. (C) | Quality |
|---|---|---|---|---|---|
| 3 | Klucel™ E | 80,000 | 100 | 138/104 | Excellent |
| 4 | Klucel™ E | 80,000 | 100 | 127/99 | Good |
| 5 | Klucel™ J | 140,000 | 110 | 193/143 | Excellent |
| 6 | Klucel™ J | 140,000 | 110 | 182/127 | Fair |
| Comp. 3 | Klucel™ G | 370,000 | 130 | 182/127 | Poor |
| Comp. 4 | Klucel™ G | 370,000 | 130 | 204/143 | Poor |
| Comp. 5 | Klucel™ H | 1,150,000 | 150 | 204/-- | Poor |
| Comp. 6 | Natrosol 250 LR™ | 90,000 | 135-140 | 204/-- | Poor |
| Comp. 7 | Methocel F4M™ | unknown | unknown | 204/-- | Poor |

The photopolymerizable element was then exposed to 365 nm UV light through an image bearing negative for 6 minutes. The image bearing negative was removed, and the photopolymerizable element was then placed on a transport element maintained at 66°C and contacted with an absorbent material which was attached to second heated transport element. The temperature of this second heated element was allowed to vary and is called the developing roll temperature. The temperature of the photopolymerizable surface was also measured. Klucel™ E and J gave acceptable results in the temperature range at which the photopolymerizable element is developed. These two materials were either completely removed or had only a few spots in which the release layer was not completely removed. In contrast Klucel™ G was left on several image areas of the plates after development. Klucel™ H, Natrosol™, and Methocel™ were still very viscous at the developing temperatures, and the coating remained on the top of the plate even at the high end of the developing temperature range for this particular photosensitive composition.

**Claims**

1.  A multilayered, photosensitive sheet comprising:
    A) a flexible substrate,
    B) a layer of a photosensitive, elastomeric composition that is not aqueous dispersible, and
    C) a release layer comprising a thermoplastic, cellulose based polymer which softens sufficiently to be removed by contact with an absorbent material in the developing temperature range of the photosensitive composition.

2. The sheet of claim 1 in which the cellulose-based polymer softens at less than 130°C.

3. The sheet of claim 1 in which the cellulose-based polymer is hydroxyalkyl cellulose.

4. The sheet of claim 3 in which the hydroxyalkyl cellulose is hydroxypropyl cellulose.

5. The sheet of claim 4 in which the hydroxypropyl cellulose has a molecular weight less than 300,000.

6. The sheet of claim 4 in which the photosensitive curable elastomer comprises
   A) a thermoplastic elastomeric block copolymer,
   B) an acrylate cross-linking agent, and
   C) a photoinitiator.

7. The sheet of claim 1 in which the release layer is less than 10 microns thick.

8. The sheet of claim 1 in which the release layer further comprises an antistatic agent.

9. A process for producing a flexographic printing plate from the sheet of claim 1 in which the release layer (C) is contacted with an image-bearing film; the photosensitive elastomeric composition (B) is image-wise cured by exposure to actinic radiation through the image-bearing film; the image-bearing film is removed; and the sheet is thermally developed by contacting the surface of the sheet bearing the imagewise cured elastomer with an absorbent material at surface temperatures between 95 and 150°C.